# EUROPEAN PATENT APPLICATION

(11) **EP 4 636 828 A1**
(43) Date of publication of application: **22.10.2025**
(21) Application number: 24747499.2
(22) Date of filing: 24.01.2024
(51) Int. Cl.: H01L 27/06, H01L 29/786, H10B 99/00, G06N 3/063, G11C 11/54

(54) **SYNAPSE CIRCUIT AND OPERATION METHOD THEREOF, AND NEUROMORPHIC DEVICE INCLUDING SYNAPSE CIRCUIT**

(30) Priority: 26.01.2023 KR 20230010066; 30.06.2023 KR 20230084990; 23.01.2024 KR 20240009969
(71) Applicant: Seoul National University R&DB Foundation, Seoul 08826 (KR)
(72) Inventor: KIM, Sangbum, Seoul 08826 (KR); KANG, Minseung, Seoul 07976 (KR)
(74) Representative: Isarpatent
(86) International application number: PCT/KR2024/095048
(87) International publication number: WO 2024/158266

(57) **Abstract**

Synapse circuits, operating methods thereof, and neuromorphic devices including a synapse circuit are disclosed. A disclosed synapse circuit may include a capacitor comprising a first electrode, a second electrode, and a dielectric layer between them, wherein the first electrode is connected to a voltage source capable of applying a positive (+) voltage, a potentiation transistor having a first source connected to the second electrode, a first drain connected to a first power source, and a first gate for applying a first control signal, a depression transistor having a second drain connected to the second electrode, a second source connected to a second power source, and a second gate for applying a second control signal, and a read transistor having a third gate connected to the second electrode, a third source connected to a word line, and a third drain connected to a bit line. The potentiation transistor, the depression transistor, and the read transistor may be n-type oxide thin film transistors including an oxide semiconductor channel. The synapse circuit may have a 3-transistor 1-capacitor (3T1C) unit circuit configuration consisting of the potentiation transistor, the depression transistor, the read transistor, and the capacitor.

## Description

### BACKGROUND

### 1. Field

The present invention relates to an electronic circuit/device, an operation method thereof and an apparatus including an electronic circuit/device, and more particularly, to a synapse circuit, an operation method thereof and a neuromorphic device including a synapse circuit.

### 2. Description of the Related Art

Neuromorphic computing systems are receiving a lot of attention as a new concept which may overcome the limitations of existing von Neumann-type computer systems. Neuromorphic computing is a technology which implements artificial intelligence behavior by imitating the human brain in hardware. Focusing on the fact that the human brain performs very complex functions but consumes only about 20W of energy, neuromorphic computing may imitate the human brain structure itself and as a result, may perform the artificial intelligence operations such as superior association, reasoning, and recognition capabilities as compared to existing von Neumann computing by using ultra-low power.

The neuromorphic crossbar structure has the advantage of being able to parallel process matrix-multiplication operations, which account for most of artificial neural network operations, through Ohm's law and Kirchhoff's law. The voltage vector input introduced from one direction is multiplied by the electrical conductivity matrix and the result may be output as a form of a current. In order to use a crossbar structure to accelerate neural network learning, a synapse device capable of linear and symmetrical weight update is required. As a synapse device, the devices based on resistive random access memory (RRAM) and phase-change random access memory (PRAM) have been studied. However, non-volatile memories such as RRAM and PRAM have relatively excellent data retention capabilities, but there is a problem in that consistent, linear and symmetric weight update is difficult.

To compensate for the shortcomings of non-volatile memory, a synapse circuit using CMOS (complementary metal oxide semiconductor) transistors and capacitors has been proposed. In the case of such a synapse circuit, unlike non-volatile memory, linear and symmetrical weight updating is possible to some extent, but there is a problem of poor data preservation ability due to leakage current. Furthermore, there are demerits that the existing synapse circuits are disadvantageous in large-scale neural network learning or long-term inference, and require additional non-volatile memory to store results.

### SUMMARY

The technological object to be achieved by the present invention is to provide a synapse circuit with low leakage current by applying an n-type oxide thin film transistor including an oxide semiconductor channel.

The technological object to be achieved by the present invention is to provide a synapse circuit which may have high accuracy during long-term inference and learning processes by storing learned weights for a long time by using an n-type oxide thin film transistor.

In addition, the technological object to be achieved by the present invention is to provide an operation method of a synapse circuit which may improve the linearity and symmetry of weight update in the operation of the synapse circuit described above.

Furthermore, the technological object to be achieved by the present invention is to provide a neuromorphic device (neuromorphic system) including the synapse circuit described above.

The objects to be solved by the present invention are not limited to the objects mentioned above, and other objects not mentioned will be understood by those skilled in the art from the description below.

According to an embodiment of the present invention, there is provided a synapse circuit comprising: a capacitor including a first electrode and a second electrode and a dielectric layer between them, wherein the first electrode is connected to a voltage source capable of applying a positive (+) voltage; a potentiation transistor having a first source connected to the second electrode, a first drain connected to a first power source, and a first gate for applying a first control signal; a depression transistor having a second drain connected to the second electrode, a second source connected to a second power source, and a second gate for applying a second control signal; and a read transistor having a third gate connected to the second electrode, a third source connected to a word line, and a third drain connected to a bit line, wherein the potentiation transistor, the depression transistor, and the read transistor are n-type oxide thin film transistors including an oxide semiconductor channel, and wherein the synapse circuit has a 3T1C (3-transistor 1-capacitor) unit circuit configuration composed of the potentiation transistor, the depression transistor, the read transistor, and the capacitor.

The oxide semiconductor channel may include at least one of amorphous InGaZnO, InGaO, InSnO, and InSnZnO.

The synapse circuit may be configured such that a first gate voltage may be applied to the first gate as the first control signal, and a second gate voltage may be applied to the second gate as the second control signal.

The synapse circuit may be configured such that in a potentiation operation for the capacitor using the potentiation transistor and a depression operation for the capacitor using the depression transistor, the positive (+) voltage may be applied to the first electrode of the capacitor by using the voltage source.

The synapse circuit may include a unit cell, and the unit cell may include the 3T1C unit circuit configuration and a selection device for a selection operation on the 3T1C unit circuit configuration.

The selection device may include a first AND gate circuit connected to the first gate and a second AND gate circuit connected to the second gate.

The selection device may include a first selection transistor connected to the first gate and a second selection transistor connected to the second gate, and each of the first selection transistor and the second selection transistor may have a dual gate structure or a double gate structure.

The selection device may include a 1-1 selection transistor and a 1-2 selection transistor connected in series to the first gate, and a 2-1 selection transistor and a 2-2 selection transistor connected in series to the second gate.

Each of the potentiation transistor and the depression transistor may have a dual gate structure or a double gate structure for a selection operation.

Two potentiation transistors may be connected in series and arranged between the second electrode and the first power source, two depression transistors may be connected in series and arranged between the second electrode and the second power source, and the synapse circuit may be configured to perform a selection operation by using the two potentiation transistors and the two depression transistors.

The synapse circuit may include a plurality of the word lines; a plurality of bit lines crossing the plurality of word lines; and a plurality of unit cells disposed at intersections of the plurality of word lines and the plurality of bit lines, and each of which includes the 3T1C unit circuit configuration.

The voltage source and the second power source may be integrated or identical to each other.

The synapse circuit may include a first signal line connected to the first gate; a second signal line connected to the second gate; and a third signal line perpendicular to the first and second signal lines and connected to the voltage source.

The synapse circuit may further include a p-type transistor connected between the potentiation transistor and the first power source, wherein the p-type transistor may include a fourth source connected to the first drain, a fourth drain connected to the first power source, and a fourth gate for applying a third control signal.

A channel resistance of the p-type transistor may be higher than a channel resistance of the potentiation transistor.

The fourth gate of the p-type transistor and the first gate of the potentiation transistor may be connected to one signal input unit, and the synapse circuit may further include an inverter disposed between the signal input unit and the fourth gate or between the signal input unit and the first gate.

According to another embodiment of the present invention, a neuromorphic device including the above-described synapse circuit is provided.

According to another embodiment of the present invention, there is provided an operation method of the above-described synapse circuit comprising: performing a depression operation on the capacitor by using the depression transistor, and wherein the positive (+) voltage is applied to the first electrode of the capacitor by using the voltage source in the performing a depression operation on the capacitor.

The method may include performing a potentiation operation on the capacitor by using the potentiation transistor, and the positive (+) voltage may be applied to the first electrode of the capacitor by using the voltage source in the performing a potentiation operation on the capacitor.

A first gate voltage applied to the first gate as the first control signal may be higher than a second gate voltage applied to the second gate as the second control signal.

According to another embodiment of the present invention, there is provided an operation method of a synapse circuit comprising: applying a high voltage corresponding to a positive (+) voltage to the first electrode of the capacitor and the second source of the depression transistor; and applying a low voltage lower than the high voltage to the first electrode of the capacitor and the second source of the depression transistor, and wherein, in the applying a low voltage to the first electrode of the capacitor and the second source of the depression transistor, a potentiation operation is performed on the capacitor by using the potentiation transistor, or a depression operation is performed on the capacitor by using the depression transistor.

According to embodiments of the present invention, a synapse circuit with low leakage current may be implemented by applying an n-type oxide thin film transistor including an oxide semiconductor channel. In particular, according to the embodiments, it is possible to implement a synapse circuit which may have high accuracy during long-term inference and learning processes by storing learned weights for a long time by using an n-type oxide thin film transistor.

Furthermore, according to embodiments of the present invention, it is possible to implement an operation method of a synapse circuit which may improve the linearity and symmetry of weight update in the operation of the synapse circuit described above.

Therefore, according to embodiments of the present invention, it is possible to implement a synapse circuit and its operating method which enable linear and symmetrical weight updating and have excellent data preservation capabilities. Since this synapse circuit is capable of linear and symmetrical weight update and has excellent weight preservation ability, it may show high final accuracy even in complex artificial neural networks with long learning cycles and may be usefully applied to long-term inference and large-scale neural networks.

A neuromorphic device (neuromorphic system) with excellent performance may be implemented by applying the synapse circuit according to embodiments of the present invention.

However, the effects of the present invention are not limited to the above effects and may be expanded in various ways without departing from the technological spirit and scope of the present invention.

### BRIEF DESCRIPTION OF THE DRAWINGS

FIG. 1 is a circuit diagram showing a synapse circuit according to an embodiment of the present invention.
FIG. 2 is a cross-sectional diagram illustrating an n-type oxide thin film transistor which may be applied to a synapse circuit according to an embodiment of the present invention.
FIG. 3 is a graph illustrating the results obtained by evaluating data retention characteristics of a synapse circuit according to an embodiment of the present invention.
FIG. 4 is a graph illustrating weight update characteristics of a synapse circuit according to an embodiment of the present invention.
FIG. 5 is a circuit diagram illustrating a synapse circuit according to another embodiment of the present invention.
FIG. 6 is a circuit diagram illustrating a synapse circuit according to another embodiment of the present invention.
FIG. 7 is a circuit diagram illustrating a synapse circuit according to another embodiment of the present invention.
FIG. 8 is a circuit diagram illustrating a synapse circuit according to another embodiment of the present invention.
FIG. 9 is a circuit diagram illustrating a synapse circuit according to another embodiment of the present invention.
FIG. 10 is a cross-sectional diagram illustrating a transistor having a dual gate structure which may be applied to a synapse circuit according to an embodiment of the present invention.
FIG. 11 is a circuit diagram illustrating a synapse circuit according to another embodiment of the present invention.
FIG. 12 is a cross-sectional diagram illustrating a transistor with a double gate structure which may be applied to a synapse circuit according to an embodiment of the present invention.
FIG. 13 is a circuit diagram illustrating a synapse circuit according to another embodiment of the present invention.
FIG. 14 is a circuit diagram illustrating a synapse circuit according to another embodiment of the present invention.
FIG. 15 and FIG. 16 are signal waveform diagrams for explaining an operation method of a synapse circuit according to an embodiment of the present invention.
FIG. 17 is a circuit diagram for explaining an operation method of a synapse circuit according to an embodiment of the present invention.
FIG. 18 is a graph illustrating the results of improved linearity and symmetry of weight update of a synapse circuit according to an operation method according to an embodiment of the present invention.
FIG. 19 is a circuit diagram illustrating a synapse circuit according to another embodiment of the present invention.
FIG. 20 is a circuit diagram illustrating a synapse circuit according to another embodiment of the present invention.
FIG. 21 is a signal waveform diagram for explaining an operation method of a synapse circuit according to another embodiment of the present invention.
FIG. 22 is a circuit diagram illustrating a synapse circuit according to another embodiment of the present invention.
FIG. 23 is a circuit diagram illustrating a synapse circuit according to another embodiment of the present invention.
FIG. 24 is a circuit diagram illustrating a synapse circuit according to another embodiment of the present invention.

### DETAILED DESCRIPTION

Hereinafter, the embodiments of the present invention will be described in detail with reference to the accompanying drawings.

The embodiments of the present invention to be described below are provided to more clearly explain the present invention to those skilled in the art, and the scope of the present invention is not limited by the following embodiments, and the embodiments may be modified in many different forms.

The terms used in this specification are used to describe specific embodiments and are not intended to limit the present invention. The terms indicating a singular form used herein may include plural forms unless the context clearly indicates otherwise. Also, as used herein, the terms, "comprise" and/or "comprising" specify the presence of the stated shape, step, number, operation, member, element, and/or group thereof and does not exclude the presence or addition of one or more other shapes, steps, numbers, operations, elements, elements and/or groups thereof. In addition, the term, "connection" used in this specification means not only a direct connection of certain members, but also a concept including an indirect connection in which other members are interposed between the members.

In addition, in the present specification, when a member is said to be located "on" another member, this arrangement includes not only a case in which a member is in contact with another member, but also a case where another member exists between the two members. As used herein, the term, "and/or" includes any one and all combinations of one or more of the listed items. In addition, the terms of degree such as "about" and "substantially" used in the present specification are used as a range of values or degrees, or as a meaning close thereto, taking into account inherent manufacturing and substance tolerances, and exact or absolute numbers provided to aid in the understanding of this application are used to prevent the infringers from unfairly exploiting the stated disclosure.

Hereinafter, embodiments of the present invention will be described in detail with reference to the accompanying drawings. A size or a thickness of areas or parts shown in the accompanying drawings may be slightly exaggerated for clarity of the specification and convenience of description. The same reference numbers indicate the same configuring elements throughout the detailed description.

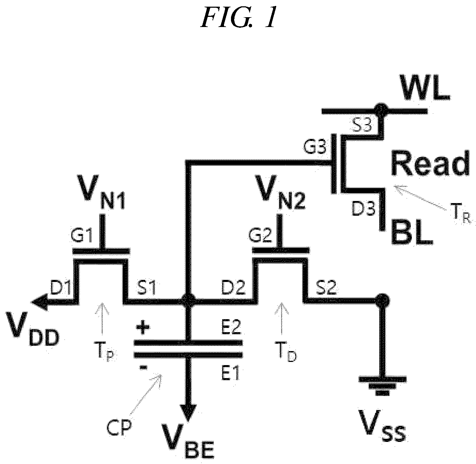

FIG. 1 is a circuit diagram illustrating a synapse circuit according to an embodiment of the present invention.

Referring to FIG. 1, the synapse circuit according to an embodiment of the present invention may include a capacitor CP, a potentiation transistor T_{P}, a depression transistor T_{D}, and a read transistor T_{R}. The potentiation transistor T_{P} and depression transistor T_{D} may be said to be update transistors for updating the weight.

The capacitor CP may include a first electrode E1, a second electrode E2, and a dielectric layer disposed between them. For example, the first electrode E1 may be a lower electrode and the second electrode E2 may be an upper electrode, but vice versa. The first electrode E1 may be connected to a voltage source capable of applying a positive (+) voltage. Here, the positive (+) voltage may be expressed as V_{BE}. The voltage source may be directly connected to the first electrode E1. The voltage source may be, for example, a constant voltage source.

The potentiation transistor T_{P} may include a first source S1 connected to the second electrode E2 of the capacitor CP, a first drain D1 connected to a first power source, and a first gate G1 for applying a first control signal. The power voltage applied from the first power source to the first drain D1 may be expressed as V_{DD}. V_{DD} may have a positive (+) voltage level. The first control signal may be a first gate voltage V_{N1}.

The depression transistor T_{D} may include a second drain D2 connected to the second electrode E2 of the capacitor CP, a second source S2 connected to a second power source, and a second gate G2 for applying a second control signal. The power voltage applied from the second power source to the second source S2 may be expressed as Vss. Vss may be a ground GND voltage, but in some cases, it may be a certain negative (-) voltage. The second control signal may be a second gate voltage V_{N2}. The first source S1 of the potentiation transistor T_{P} and the second drain D2 of the depression transistor T_{D} may be connected to each other or integrated with each other.

The read transistor T_{R} may include a third gate G3 connected to the second electrode E2 of the capacitor CP, a third source S3 connected to a word line WL, and a third drain D3 connected to a bit line BL. The voltage applied from the capacitor CP to the third gate G3 may vary, and the read current flowing through the bit line BL may vary depending on the amount of charge stored in the capacitor CP. In other words, the read current may vary depending on the voltage of the capacitor CP. The data (weight) stored in the capacitor CP may be determined by using the read transistor T_{R}.

The potentiation transistor T_{P}, the depression transistor T_{D}, and the read transistor T_{R} may be n-type oxide thin film transistors including an oxide semiconductor channel. For example, the oxide semiconductor channel may include at least one of amorphous InGaZnO, InGaO, InSnO, InSnZnO, etc. InGaZnO is indium-gallium-zinc oxide and may be expressed as IGZO. InGaO is indium-gallium oxide and may be expressed as IGO. InSnO is indium-tin oxide and may be expressed as ITO. InSnZnO is indium-tin-zinc oxide and may be expressed as ITZO. The oxide semiconductor channel has a large bandgap and may have very low leakage current characteristics. Therefore, when manufacturing a synapse circuit by applying an n-type oxide thin film transistor including the oxide semiconductor channel, leakage current may be suppressed and data retention performance may be greatly improved.

In the case of memory which stores information in a capacitor, such as DRAM (dynamic random access memory), information is lost over time due to charge leakage through a transistor or insulating film. When learning an artificial neural network, if the learned weights disappear over time, learning becomes difficult or the final learned result may not be maintained for a long time. In an embodiment of the present invention, an oxide semiconductor channel made of a material such as amorphous InGaZnO (a-IGZO) may have a remarkably lower leakage current than a silicon transistor due to a high bandgap. Therefore, in the embodiment of the present invention, the weights may be preserved for a long time because the charge stored in the capacitor CP is stored for a long time, and as compared to devices manufactured with a CMOS structure based on silicon, it may be advantageous for long-term inference and learning of large-scale neural networks, and the accuracy of learning may be improved. Here, the device manufactured with the CMOS structure is configured to include a p-channel metal oxide semiconductor (PMOS) transistor and an n-channel metal oxide semiconductor (NMOS) transistor, and may have a 3-transistor 1-capacitor (3T1C) configuration.

Furthermore, the channel material of the potentiation transistor T_{P}, the channel material of the depression transistor T_{P}, and the channel material of the read transistor T_{P} may be the same, but at least two of them may be different. In addition, while applying the same or similar channel materials to the channel of the potentiation transistor T_{P}, the channel of the depression transistor T_{D} and the channel of the read transistor T_{R}, physical properties of at least two of them may be adjusted differently by changing the process conditions for the at least two of them. Through this, it may be possible to optimize physical properties and improve performance.

The synapse circuit according to an embodiment of the present invention may have a 3-transistor 1-capacitor (3T1C) unit circuit configuration composed of a potentiation transistor T_{P}, a depression transistor T_{D}, a read transistor T_{R}, and a capacitor CP. A weight potentiation operation for the capacitor CP may be performed by using the potentiation transistor T_{P}, and a weight depression operation for the capacitor CP may be performed by using the depression transistor T_{D}. The weight potentiation operation may be a process for stepwise/gradually increasing the amount of charge (voltage) of the capacitor CP. The weight depression operation may be a process of stepwise/gradually reducing the amount of charge (voltage) of the capacitor CP. The amount of charge (voltage) stored in the capacitor CP may be read by using the read transistor T_{R}.

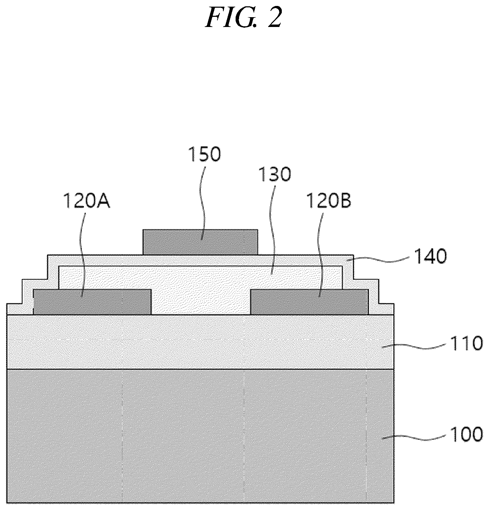

FIG. 2 is a cross-sectional diagram illustrating an n-type oxide thin film transistor which may be applied to a synapse circuit according to an embodiment of the present invention.

Referring to FIG. 2, an n-type oxide thin film transistor which may be applied to a synapse circuit according to an embodiment of the present invention may be formed on a buffer layer 110 disposed on a substrate 100. The buffer layer 110 may be an insulating layer. The n-type oxide thin film transistor may include a source 120A and a drain 120B formed on the buffer layer 110, and a channel layer 130 formed to connect the source 120A and the drain 120B. The channel layer 130 may include an oxide semiconductor material. The n-type oxide thin film transistor may include a gate insulating layer 140 formed on the channel layer 130 and a gate 150 formed on the gate insulating layer 140. However, the specific structure of the n-type oxide thin film transistor shown in FIG. 2 is merely an example and may be changed in various ways. For example, the n-type oxide thin film transistor may have a bottom-gate structure.

As described above, when a synapse circuit is manufactured by using the n-type oxide thin film transistor, leakage current may be suppressed and data retention performance may be greatly improved.

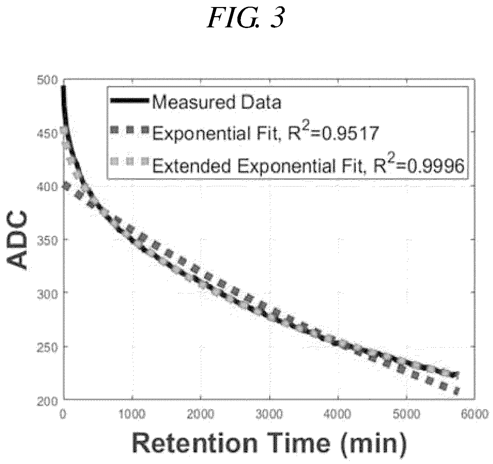

FIG. 3 is a graph illustrating the results obtained by evaluating data retention characteristics of a synapse circuit according to an embodiment of the present invention. In FIG. 3, the ADC on the Y axis refers to a value obtained by converting a magnitude of the current flowing in the bit line to an arbitrary unit. FIG. 3 includes measured data, exponential fitting data, and extended exponential fitting data.

Referring to FIG. 3, it may be seen that the synapse circuit according to an embodiment of the present invention has excellent data preservation characteristics.

Furthermore, the synapse circuit according to an embodiment of the present invention may have linear and symmetrical weight update (potentiation/depression) characteristics. According to an embodiment, in the operation of the synapse circuit, an operation method of a synapse circuit which may ensure linearity and symmetry of weight update may be implemented. In this regard, the first gate voltage V_{N1} may be applied to the first gate G1 as the first control signal, and the second gate voltage V_{N2} lower than the first gate voltage V_{N1} may be applied to the second gate G2 as the second control signal. The second gate voltage V_{N2} may be lower than the first gate voltage V_{N1}. In other words, the second gate voltage V_{N2} applied to the second gate G2 during the depression operation may be lower than the first gate voltage V_{N1} applied to the first gate G1 during the potentiation operation. The first gate voltage V_{N1} may be higher than the second gate voltage V_{N2}.

In the case of the potentiation transistor T_{P}, it is an n-type transistor, a constant voltage from the outside is applied to each of the first gate G1 and the first drain D1, and a voltage on the first source S1 side corresponds to a voltage of the capacitor CP. As programming for the capacitor CP is performed, the voltage of the capacitor CP changes, the V_{GS} (gate-source voltage) of the potentiation transistor T_{P} continues to change, and the amount of flowing charge changes. Therefore, non-linear update may occur. However, if the first gate voltage V_{N1} is sufficiently increased, the linearity of the weight update may be improved because the rate at which V_{GS} changes in the potentiation transistor T_{P} is quite small even when the voltage of the capacitor CP changes. To increase the first gate voltage V_{N1} and perform detailed programming, the pulse length of the first gate voltage V_{N1} may be adjusted.

In addition, according to an embodiment of the present invention, when performing a potentiation operation for the capacitor CP by using the potentiation transistor T_{P} and a depression operation for the capacitor CP using the depression transistor T_{D}, a positive (+) voltage V_{BE} may be applied to the first electrode E1 of the capacitor CP by using the above-described voltage source. In the step for performing a depression operation for the capacitor CP, a positive (+) voltage V_{BE} may be applied to the first electrode E1 of the capacitor CP by using the voltage source. In this case, during the depression operation, V_{DS} (a drain-source voltage) of the depression transistor T_{D} may increase. In addition, in the step for performing a potentiation operation for the capacitor CP, a positive (+) voltage V_{BE} may be applied to the first electrode E1 of the capacitor CP using the voltage source. As described above, if the first gate voltage V_{N1} is increased, the amount of current during potentiation may increase. Therefore, in order to adjust the symmetry of the weight update by increasing the amount of current during depression, a positive (+) voltage V_{BE} may be applied to the first electrode E1 of the capacitor CP. Therefore, according to an embodiment of the present invention, both of linearity and symmetry of weight update may be improved, and characteristics close to ideal weight update may be secured.

In the potentiation operation for the capacitor CP using the potentiation transistor T_{P}, the voltage applied to the first source S1 may increase by V_{BE}, and along with this, the voltage applied to each of the first gate G1 and the first drain D1 may also be increased by V_{BE}. Therefore, in the potentiation transistor T_{P}, the voltage at all three terminals (S1, G1, D1) may be increased by V_{BE}, and the effect of V_{BE} may be cancelled out. Therefore, the potentiation transistor T_{P} may operate the same as when V_{BE} is not applied.

According to one embodiment, the first gate voltage V_{N1} may be the sum of the reference gate voltage and V_{BE}. Here, the reference gate voltage may be about 2 to 4 V, as a non-limiting example. As a non-limiting example, the second gate voltage V_{N2} may be approximately 0.5 to 2 V. However, the specific ranges of the above-described first gate voltage V_{N1} and second gate voltage V_{N2} are merely examples, an operation is possible even at voltages outside the presented range, the range of the first gate voltage V_{N1} and the second gate voltage V_{N2} also varies depending on V_{BE}. V_{BE} may be appropriately selected within a wide voltage range.

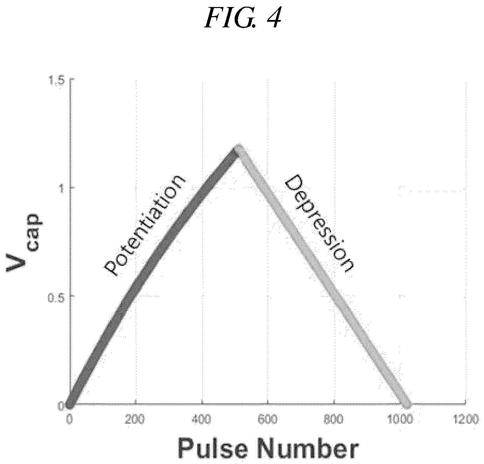

FIG. 4 is a graph illustrating the weight update characteristics of a synapse circuit according to an embodiment of the present invention. The X-axis of FIG. 4 represents the number of times of application of an update pulse, and the Y-axis represents the voltage of the capacitor.

Referring to FIG. 4, it may be seen that the synapse circuit according to an embodiment of the present invention exhibits excellent linearity and symmetry in weight update (potentiation/depression).

An operation method of a synapse circuit according to an embodiment of the present invention may include performing a depression operation for the capacitor by using the depression transistor, and in the step for performing a depression operation for the capacitor, a positive (+) voltage may be applied to the first electrode of the capacitor by using the voltage source. The operation method of the synapse circuit may include performing a potentiation operation for the capacitor using the potentiation transistor, and in the step for performing a potentiation operation on the capacitor, a positive (+) voltage may be applied to the first electrode of the capacitor by using the voltage source. Furthermore, in the operation method of the synapse circuit, the first gate voltage applied to the first gate as the first control signal may be higher than the second gate voltage applied to the second gate as the second control signal. In addition, all of the methods previously described with reference to FIGS. 1 to 4 may be applied to the operating method of the synapse circuit according to the embodiment.

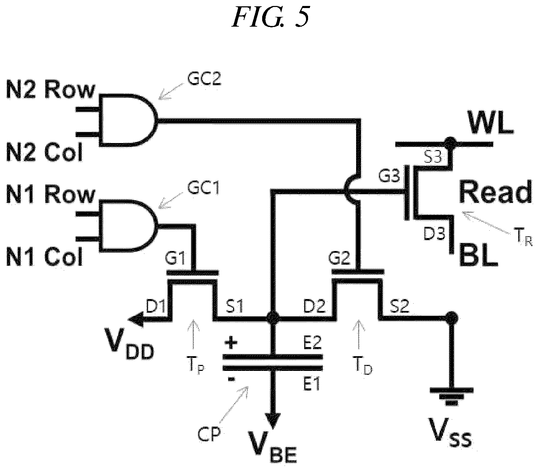

A synapse circuit according to an embodiment of the present invention may include a unit cell, and the unit cell may include the 3T1C unit circuit configuration and a selection device for a selection operation thereon. A plurality of unit cells may be arranged to form an array, and a unit cell to be operated may be selected and operated from the plurality of unit cells. The selection device may serve to enable this selection operation. The specific configuration which the selection device may have will be described with reference to FIGS. 5 to 8, and the like.

FIG. 5 is a circuit diagram illustrating a synapse circuit according to another embodiment of the present invention.

Referring to FIG. 5, the synapse circuit according to this embodiment may include a capacitor CP, a potentiation transistor T_{P}, a depression transistor T_{D}, and a read transistor T_{R} as described in FIG. 1. The synapse circuit may have a 3T1C unit circuit configuration consisting of the potentiation transistor T_{P}, the depression transistor T_{D}, and the read transistor T_{R} and the capacitor CP.

Furthermore, the synapse circuit may further include a selection device. The selection device may include a first AND gate circuit GC1 connected to the first gate G1 and a second AND gate circuit GC2 connected to the second gate G2. The first AND gate circuit GC1 and the second AND gate circuit GC2 may include a CMOS transistor configuration.

The first AND gate circuit GC1 may have two input terminals and one output terminal, and the output terminal may be connected to the first gate G1. An N1 column signal line (N1 Col) and an N1 row signal line (N1 Row) may be connected to the two input terminals of the first AND gate circuit GC1, respectively. Here, N1 represents a potentiation transistor. The second AND gate circuit GC2 may have two input terminals and one output terminal, and the output terminal may be connected to the second gate G2. An N2 column signal line (N2 Col) and an N2 row signal line (N2 Row) may be connected to the two input terminals of the second AND gate circuit GC2, respectively. Here, N2 represents a depression transistor.

The selection operation may be implemented in such a way that V_{ON} is applied to the update transistor (T_{P} or T_{D}) and the charge of the capacitor CP is updated only when the update signal is simultaneously input to both input terminals of the AND gate circuit (GC1 or GC2).

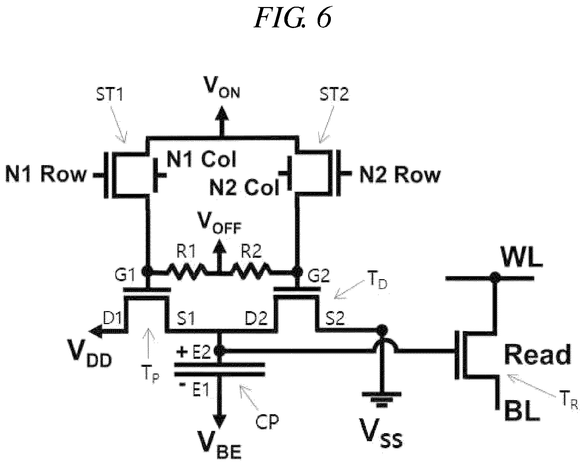

FIG. 6 is a circuit diagram illustrating a synapse circuit according to another embodiment of the present invention.

Referring to FIG. 6, the synapse circuit according to this embodiment may include a capacitor CP, a potentiation transistor T_{P}, a depression transistor T_{D}, and a read transistor T_{R} as described in FIG. 1. The synapse circuit may have a 3T1C unit circuit configuration consisting of the potentiation transistor T_{P}, the depression transistor T_{D}, and the read transistor T_{R} and the capacitor CP.

Furthermore, the synapse circuit may further include a selection device. The selection device may include a first selection transistor ST1 connected to the first gate G1 and a second selection transistor ST2 connected to the second gate G2. The first selection transistor ST1 and the second selection transistor ST2 may be, for example, an n-type oxide thin film transistor including an oxide semiconductor channel.

Each of the first selection transistor ST1 and the second selection transistor ST2 may have a dual gate structure. The first selection transistor ST1 may include a lower gate and an upper gate. Similarly, the second selection transistor ST2 may include a lower gate and an upper gate. An N1 column signal line (N1 Col) and an N1 row signal line (N1 Row) may be connected to the two gates (a lower gate and an upper gate) of the first selection transistor ST1, respectively. An N2 column signal line (N2 Col) and an N2 row signal line (N2 Row) may be connected to the two gates (a lower gate and an upper gate) of the second selection transistor ST2, respectively.

The selection operation may be implemented in such a way that only when an update signal is applied to both gates of the selection transistor (ST1 or ST2), V_{ON} is applied to the update transistor (T_{P} or T_{D}) and the amount of charge in the capacitor CP is updated.

Meanwhile, a V_{OFF} power source may be further connected between the first gate G1 and the second gate G2, a first resistor R1 may be disposed between the first gate G1 and the V_{OFF} power source, and the second resistor R2 may be disposed between the gate G2 and the V_{OFF} power source. When the first selection transistor ST1 and the second selection transistor ST2 are in the OFF state, since the resistance of the first selection transistor ST1 and the second selection transistor ST2 is much larger, the first gate G1 and the second gate G2 may be electrically connected to the V_{OFF} power supply. When the first selection transistor ST1 is turned on, since the resistance of the first selection transistor ST1 is lowered, the first gate G1 may be electrically connected to V_{ON}. Similarly, when the second selection transistor ST2 is turned on, since the resistance of the second selection transistor ST2 is lowered, the second gate G2 may be electrically connected to V_{ON}.

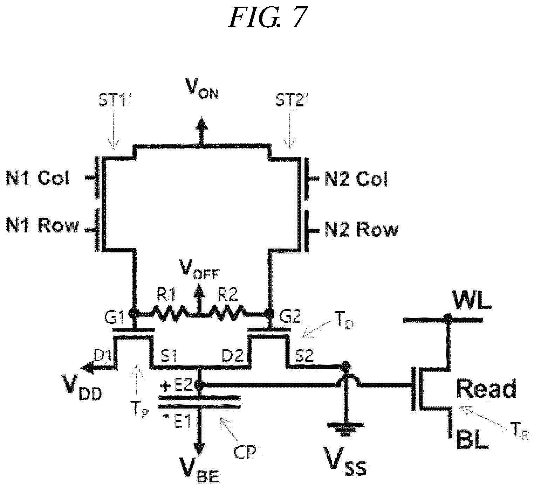

FIG. 7 is a circuit diagram illustrating a synapse circuit according to another embodiment of the present invention.

Referring to FIG. 7, the synapse circuit according to this embodiment may include a capacitor CP, a potentiation transistor T_{P}, a depression transistor T_{D}, and a read transistor T_{R} as described in FIG. 1. The synapse circuit may have a 3T1C unit circuit configuration consisting of the potentiation transistor T_{P}, the depression transistor T_{D}, and the read transistor T_{R} and the capacitor CP.

Furthermore, the synapse circuit may further include a selection device. The selection device may include a first selection transistor ST1' connected to the first gate G1 and a second selection transistor ST2' connected to the second gate G2. The first selection transistor ST1' and the second selection transistor ST2' may be, for example, an n-type oxide thin film transistor including an oxide semiconductor channel.

Each of the first selection transistor ST1' and the second selection transistor ST2' may have a double gate structure. The first selection transistor ST1' may include two gates laterally spaced apart from each other. Similarly, the second selection transistor ST2' may include two gates laterally spaced apart from each other. An N1 column signal line (N1 Col) and an N1 row signal line (N1 Row) may be connected to the two gates of the first selection transistor ST1', respectively. An N2 column signal line (N2 Col) and an N2 row signal line (N2 Row) may be connected to the two gates of the second selection transistor ST2', respectively.

The selection operation may be implemented in such a way that only when an update signal is applied to both gates of the selection transistor (ST1' or ST2'), V_{ON} is applied to the update transistor (T_{P} or T_{D}) and the charge amount of the capacitor CP is updated.

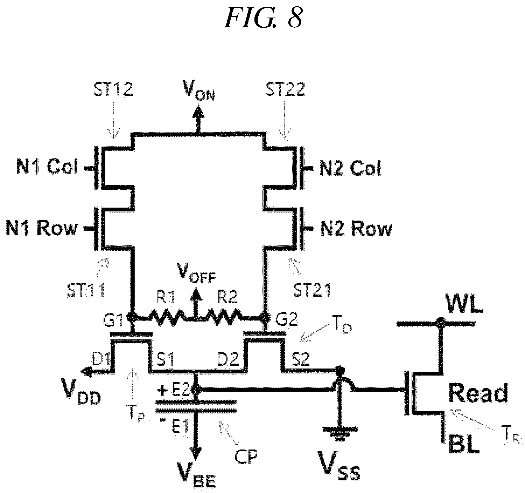

FIG. 8 is a circuit diagram illustrating a synapse circuit according to another embodiment of the present invention.

Referring to FIG. 8, the synapse circuit according to this embodiment may include a capacitor CP, a potentiation transistor T_{P}, a depression transistor T_{D}, and a read transistor T_{R} as described in FIG. 1. The synapse circuit may have a 3T1C unit circuit configuration consisting of the potentiation transistor T_{P}, the depression transistor T_{D}, and the read transistor T_{R} and the capacitor CP.

Furthermore, the synapse circuit may further include a selection device. The selection device may include a 1-1 selection transistor ST11 and a 1-2 selection transistor ST12 connected in series to the first gate G1, a 2-1 selection transistor ST21 and a 2-2 selection transistor ST22 connected in series to the second gate G2. The 1-1 selection transistor ST11, the 1-2 selection transistor ST12, the 2-1 selection transistor ST21, and the 2-2 selection transistor ST22 include, for example, may be an n-type oxide thin film transistor containing an oxide semiconductor channel.

An N1 row signal line (N1 Row) and an N1 column signal line (N1 Col) may be connected to the gate of the 1-1 selection transistor ST11 and the gate of the 1-2 selection transistor ST12, respectively. Similarly, the N2 row signal line (N2 Row) and the N2 column signal line (N2 Col) may be connected to the gate of the 2-1 selection transistor ST21 and the gate of the 2-2 selection transistor ST22, respectively.

The selection operation may be implemented according to the method wherein only when an update signal is applied to both the gate of the 1-1 selection transistor ST11 and the gate of the 1-2 selection transistor ST12, V_{ON} is applied to the potentiation transistor TP so that the charge of the capacitor CP may be updated, and only when an update signal is applied to both of the gate of the 2-1 selection transistor ST21 and the gate of the 2-2 selection transistor ST22, V_{ON} is applied to the depression transistor T_{D} so that the charge of the capacitor CP may be updated.

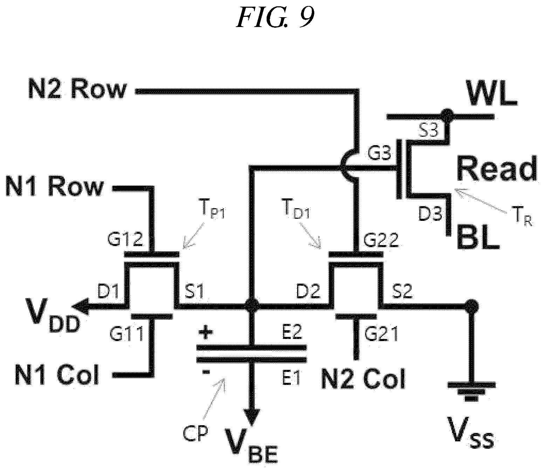

According to another embodiment of the present invention, the potentiation transistor and the depression transistor may have a dual gate structure or a double gate structure for a selection operation. In this case, the selection operation may be implemented by using the structures of the potentiation transistor and the depression transistor themselves without using a separate selection device. The examples are shown in FIG. 9 to FIG. 12.

FIG. 9 is a circuit diagram illustrating a synapse circuit according to another embodiment of the present invention.

Referring to FIG. 9, in the synapse circuit according to this embodiment, a potentiation transistor T_{P1} may have a dual gate structure including a first lower gate G11 and a first upper gate G12. Furthermore, a depression transistor T_{D1} may have a dual gate structure including a second lower gate G21 and a second upper gate G22. An N1 column signal line (N1 Col) and an N1 row signal line (N1 Row) may be connected to the first lower gate G11 and the first upper gate G12 of the potentiation transistor T_{P1}, respectively. An N2 column signal line (N2 Col) and an N2 row signal line (N2 Row) may be connected to the second lower gate G21 and the second upper gate G22 of the depression transistor T_{D1}, respectively.

The selection operation may be implemented according to the method wherein only when an update signal is applied to both of the first lower gate G11 and the first upper gate G12 of the potentiation transistor T_{P1}, the potentiation transistor T_{P1} is turned on and the charge of the capacitor CP is updated, and only when an update signal is applied to both of the second lower gate G21 and the second upper gate G22 of the depression transistor T_{D1}, the depression transistor T_{D1} is turned on and the charge amount of the capacitor CP is updated.

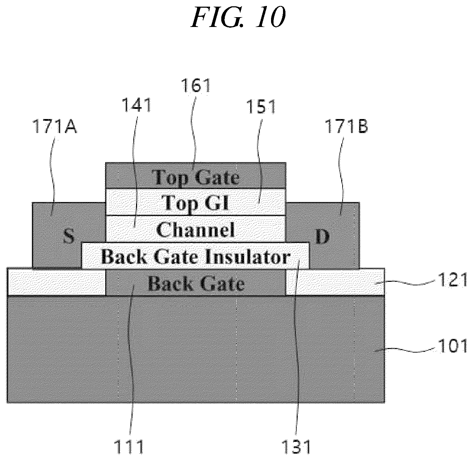

FIG. 10 is a cross-sectional diagram illustrating a transistor having a dual gate structure which may be applied to a synapse circuit according to an embodiment of the present invention.

Referring to FIG. 10, a transistor having a dual gate structure may be formed on the substrate 101. The transistor may include a lower gate 111 disposed on the substrate 101 and an insulating layer 121 formed around the lower gate 111. The transistor may include a first gate insulating layer 131, a channel layer 141, a second gate insulating layer 151, and an upper gate 161 sequentially arranged on the lower gate 111. Furthermore, the transistor may include a source 171A connected to (contact) a first region of the channel layer 141 and a drain 171B connected to (contact) a second region of the channel layer 141. However, the specific structure of the transistor having a dual gate structure shown in FIG. 10 is an example and may be changed in various ways.

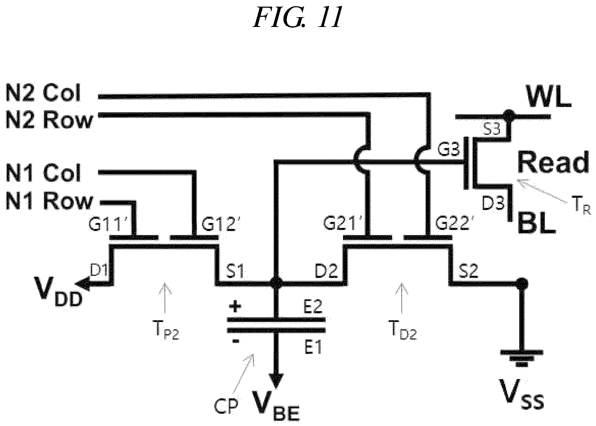

FIG. 11 is a circuit diagram illustrating a synapse circuit according to another embodiment of the present invention.

Referring to FIG. 11, in the synapse circuit according to this embodiment, a potentiation transistor T_{P2} has a double gate structure including a 1-1 gate G11' and a 1-2 gate G12' which are laterally spaced apart from each other. Furthermore, a depression transistor T_{D2} may have a double gate structure including a 2-1 gate G21' and a 2-2 gate G22' which are laterally spaced apart from each other. An N1 row signal line (N1 Row) and an N1 column signal line (N1 Col) may be connected to the 1-1 gate G11' and the 1-2 gate G12' of the potentiation transistor T_{P2}, respectively. An N2 row signal line (N2 Row) and an N2 column signal line (N2 Col) may be connected to the 2-1st gate G21' and the 2-2nd gate G22' of the depression transistor T_{D2}, respectively.

The selection operation may be implemented according to the method wherein only when an update signal is applied to both of the 1-1 gate G11' and the 1-2 gate G12' of the potentiation transistor T_{P2} is turned on, and the charge amount of the capacitor CP is updated, and only when an update signal is applied to both the 2-1 gate G21' and the 2-2 gate G22' of the depression transistor T_{D2}, the depression transistor T_{D2} is turned on and the charge amount of the capacitor CP is updated.

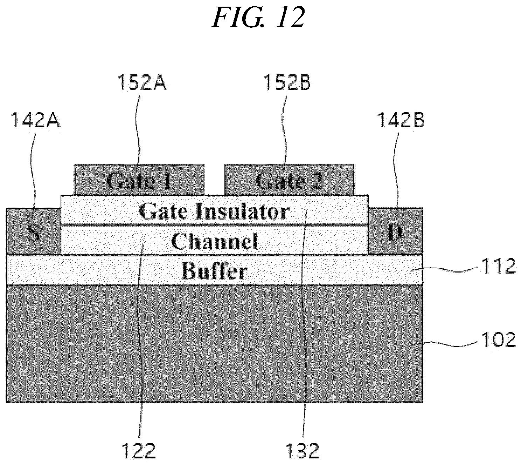

FIG. 12 is a cross-sectional diagram illustrating a transistor with a double gate structure which may be applied to a synapse circuit according to an embodiment of the present invention.

Referring to FIG. 12, a transistor having a double gate structure may be formed on a buffer layer 112 disposed on a substrate 102. The buffer layer 112 may be an insulating layer. The transistor may include a channel layer 122 disposed on the buffer layer 112 and a gate insulating layer 132 disposed on the channel layer 122. The transistor may include a source 142A connected to (contact) a first region of the channel layer 122 and a drain 142B connected to (contact) a second region of the channel layer 122. Furthermore, the transistor may include two gates 152A and 152B disposed on the gate insulating layer 132. The two gates 152A and 152B may be laterally spaced apart from each other. However, the specific structure of the transistor having a double gate structure shown in FIG. 12 is only an example and may be changed in various ways.

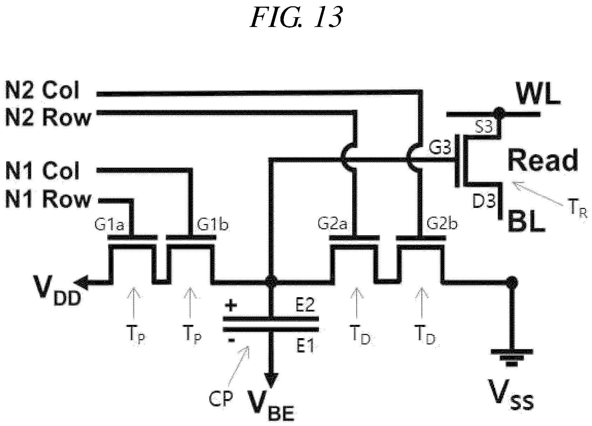

FIG. 13 is a circuit diagram illustrating a synapse circuit according to another embodiment of the present invention.

Referring to FIG. 13, in the synapse circuit according to this embodiment, two potentiation transistors T_{P} may be connected in series and arranged between the second electrode E2 of the capacitor CP and the first power source (i.e., a power source to which V_{DD} is applied.). Similarly, two depression transistors T_{D} may be connected in series and arranged between the second electrode E2 of the capacitor CP and the second power source (i.e., a power source to which V_{SS} is applied.). The synapse circuit may be configured to perform a selection operation by using two potentiation transistors T_{P} and two depression transistors T_{D}.

An N1 row signal line (N1 Row) and an N1 column signal line (N1 Col) may be connected to the first gates (G1a, G1b) of the two potentiation transistors T_{P}, respectively. An N2 row signal line (N2 Row) and an N2 column signal line (N2 Col) may be connected to the second gates (G2a, G2b) of the two depression transistors T_{D}, respectively.

The selection operation may be implemented in such a way that the charge amount of the capacitor CP is updated (potentiation) only when an update signal is applied to both of the first gates (G1a and G1b) of the two potentiation transistors T_{P}, and the charge amount of the capacitor CP is updated (depression) only when an update signal is applied to both of the second gate (G2a, G2b) of the two depression transistors T_{D}.

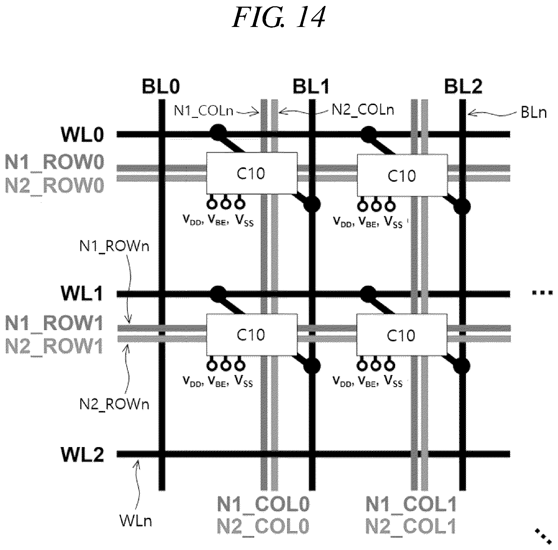

FIG. 14 is a circuit diagram illustrating a synapse circuit according to another embodiment of the present invention.

Referring to FIG. 14, the synapse circuit according to an embodiment of the present invention may include a plurality of word lines WLn, a plurality of bit lines BLn crossing the plurality of word lines WLn, and a plurality of unit cells C10 disposed at intersections of plurality of word lines WLn and a plurality of bit lines BLn. Each of the plurality of unit cells C10 may include the 3T1C unit circuit configuration described above. Furthermore, each of the plurality of unit cells C10 may include the 3T1C unit circuit configuration and a selection device for a selection operation. Alternatively, each of the plurality of unit cells C10 may include the 3T1C unit circuit configuration and a circuit structure for a selection operation within the 3T1C unit circuit configuration.

The synapse circuit may include a plurality of N1 row signal lines (N1_ROWn) and a plurality of N2 row signal lines (N2_ROWn). Furthermore, the synapse circuit may include a plurality of N1 column signal lines (N1_COLn) and a plurality of N2 column signal lines (N2_COLn). One N1 row signal line (N1_ROWn), one N2 row signal line (N2_ROWn), one N1 column signal line (N1_COLn), and one N2 column signal line (N2_COLn) may be connected to each unit cell C10. In addition, a first power source for applying V_{DD}, a second power source for applying Vss, and a voltage source for applying a positive (+) voltage V_{BE} may be connected to the unit cell C10. The first power source, the second power source, and the voltage source may be commonly connected to a plurality of unit cells C10. Each unit cell C10 may have a synapse circuit configuration according to the embodiments described with reference to FIGS. 1 to 13. The synapse circuit in FIG. 14 may be said to have an array structure (crossbar array structure).

According to an embodiment of the present invention, a neuromorphic device to which the synapse circuit according to the above-described embodiment is applied and a system thereof may be configured. The configuration of a neuromorphic device including synapse circuits, and a system thereof is well known, and detailed description thereof will be omitted.

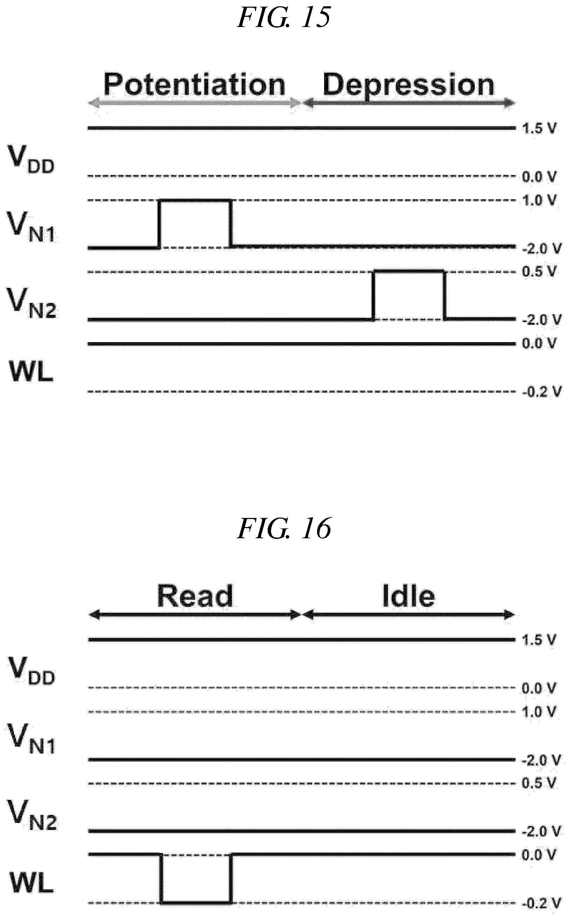

FIG. 15 and FIG. 16 are signal waveform diagrams for explaining an operation method of a synapse circuit according to an embodiment of the present invention.

Referring FIG. 15 and FIG. 16, the operation of the synapse circuit according to an embodiment of the present invention may be divided into four operating states, namely, a potentiation state, a depression state, a read state, and an idle state. Potentiation and depression, which are weight updates, may occur when an ON signal is applied to the potentiation transistor and depression transistor, respectively. The ON signal may be a predetermined pulse voltage signal. As for a read operation, when a predetermined voltage (pulse voltage) is applied to the word line WL, the weight may be read by using the current flowing in the bit line BL. In the idle state, negative (-) voltage is applied to the potentiation and the depression transistors to turn off them, and it is possible to prevent current from flowing to the read transistor by applying a ground voltage GND to the word line WL and bit line BL. The voltage signal (pulse voltage signal) may be controlled down to ns level. An analog programming may be performed by using a length and a number of a voltage signal.

The voltage levels (numerical values) shown in FIGS. 15 and 16 are merely examples and may vary. In addition, the voltage level (numerical values) shown in FIGS. 15 and 16 corresponds to the case where the ground voltage GND is applied to the first electrode of the capacitor without applying V_{BE} which is a positive (+) voltage. Therefore, depending on the embodiment, when V_{BE}, a positive (+) voltage, is applied to the first electrode of the capacitor, the voltage levels (values) may vary.

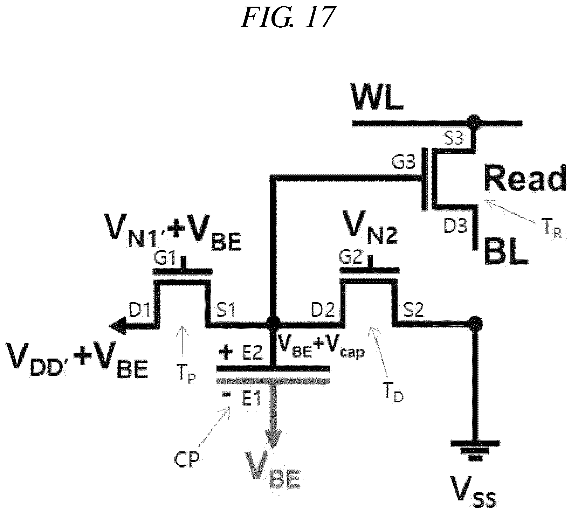

FIG. 17 is a circuit diagram for explaining an operation method of a synapse circuit according to an embodiment of the present invention.

Referring to FIG. 17, according to an embodiment of the present invention, linearity and symmetry of weight update may be improved through optimization of voltage conditions. In the case of a potentiation operation, when a high first gate voltage is used, since the rate at which V_{GS} changes for the same capacitor voltage usage section is remarkably lowered, the linearity of weight update may be improved. In the case of a depression operation, since the depression transistor T_{D} must be operated in the saturation section for linear weight reduction (depression) to occur, V_{BE}, a positive (+) voltage, is applied to the first electrode E1 of the capacitor CP so that V_{DS} of the depression transistor T_{D} may be increased. The operation of the depression transistor T_{D} in the entire saturation period may be possible by applying V_{BE}. Furthermore, as V_{DS} of the depression transistor T_{D} is increased by V_{BE}, symmetry of the weight update of the potentiation operation and the depression operation may be improved.

Meanwhile, in the potentiation operation for the capacitor CP using the potentiation transistor T_{P}, the voltage applied to the first source S1 may increase by V_{BE}, and along with this, the voltage applied to each of the first gate G1 and the first drain D1 may also be increased by V_{BE}. Therefore, in the potentiation transistor T_{P}, the voltage at all three terminals (S1, G1, D1) may be increased by V_{BE}, and the effect of V_{BE} may be cancelled out. Therefore, the potentiation transistor T_{P} may operate the same as when V_{BE} is not applied.

**In** FIG. 17, V_{N1'} means the first gate voltage when V_{BE} is not applied, that is, when the first electrode E1 is grounded, and V_{DD}' means the power voltage (power supply voltage) on the first drain D1 side when V_{BE} is not applied, that is, when the first electrode E1 is grounded. When V_{BE} is applied to the first electrode E1, the first gate voltage of the potentiation transistor T_{P} may be V_{N1'} + V_{BE}, and the power voltage on the first drain D1 side may be V_{DD'} + V_{BE}.

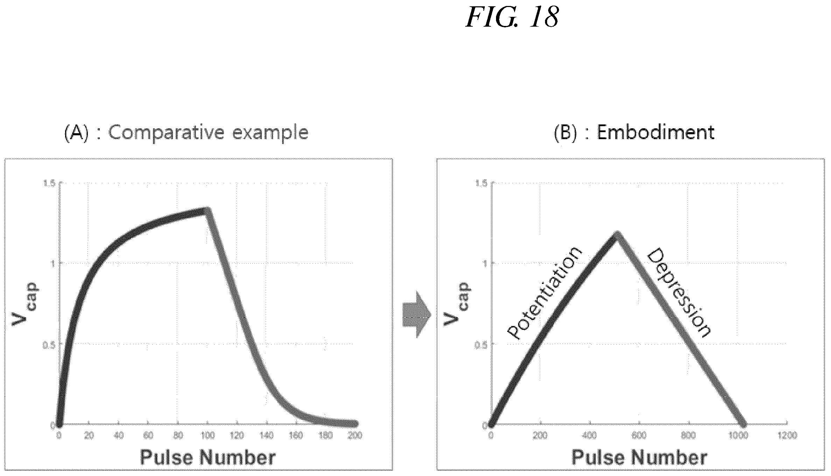

FIG. 18 is a graph illustrating the results of improved linearity and symmetry of weight update of a synapse circuit according to an operation method according to an embodiment of the present invention. (A) of FIG. 18 is a graph illustrating weight update characteristics by an operation method according to a comparative example, and (B) is a graph illustrating weight update characteristics by an operation method according to an embodiment.

Referring to FIG. 18, it may be seen that the linearity and symmetry of weight update are greatly improved by the operation method according to the embodiment of the present invention. According to an embodiment of the present invention, both of linearity and symmetry of weight update may be improved, and characteristics close to ideal weight update may be secured.

Furthermore, the conventional 5T1C synapse circuit has a structure in which two transistors are connected to all electrodes of a capacitor. That is, the conventional 5T1C synapse circuit has a structure in which two transistors are connected to each of the two electrodes of a capacitor. In this case, when all transistors are off, the capacitor is in a floating state. In the conventional 5T1C circuit, since the capacitor voltage is not clearly defined in the off state, an additional process for turning on one transistor and applying a voltage to one electrode of the capacitor is required during the read process. In this operation, there is a problem that the charge (voltage) stored in the capacitor leaks due to the parasitic resistance of the transistor. However, the synapse circuit presented in the embodiment of the present invention has the advantage that the same problems as the conventional 5T1C synapse circuit do not occur because the capacitor voltage may always have a defined state.

According to the embodiments of the present invention described above, a synapse circuit with low leakage current may be implemented by applying an n-type oxide thin film transistor including an oxide semiconductor channel. In particular, according to embodiments, it is possible to implement a synapse circuit which may have high accuracy during long-term inference and learning processes by enabling learned weights for a long time to be stored by using an n-type oxide thin film transistor. Furthermore, according to embodiments of the present invention, an operation method of a synapse circuit that may improve the linearity and symmetry of weight update in the operation of the synapse circuit described above may be implemented. Therefore, according to embodiments of the present invention, it is possible to implement a synapse circuit which is capable of performing enable linear and symmetrical weight updating and have excellent data preservation capabilities, and its operating method. Since this synapse circuit is capable of linear and symmetrical weight update and has excellent weight preservation ability, it may show high final accuracy even in complex artificial neural networks with long learning cycles and may be usefully applied to long-term inference and large-scale neural networks. A neuromorphic device (neuromorphic system) with excellent performance may be implemented by applying the synapse circuit according to embodiments of the present invention.

The synapse circuit proposed in an embodiment of the present invention is expected to be able to accelerate the matrix-vector multiplication operation of an artificial neural network by using a synapse in a crossbar structure. The synapse circuit may be utilized for the development of neuromorphic computing, which deviates from the existing von Neumann computing structure which has limitations in complex neural networks. If the synapse circuit is used, it is expected that low-power, and high-performance computational accelerator hardware which may be commercialized based on reasonable process difficulty will be implemented.

In addition, the circuit according to the embodiment of the present invention may operate as a high-density memory through the advantage that vertical processing and stacking are possible in addition to the neuromorphic field. The advantage of area reduction may be obtained through PUC (peri-under-cell) which is a deposition method on top of CMOS circuits, high integration like V-NAND (vertical-NAND) may be achieved by vertically stacking oxide semiconductor-based 3T1C, and the circuit may be used as SCM (storage class memory) with a fast operation speed comparable to DRAM. In addition, the linear and symmetrical weight update method of the 3T1C circuit proposed in the present invention may be applied not only to 3T1C which has only n-type transistors, but also to various synapse circuits such as 2T1C, 2T0C, 5T1C, and 6T1C.

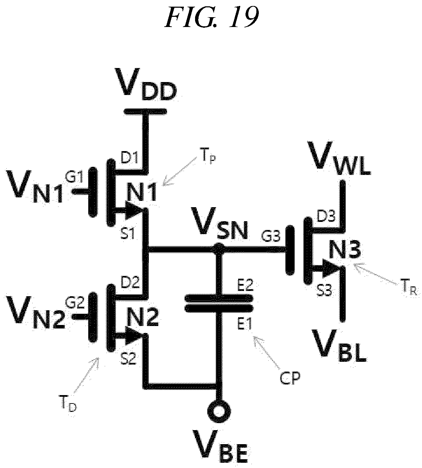

FIG. 19 is a circuit diagram illustrating a synapse circuit according to another embodiment of the present invention.

Referring to FIG. 19, the synapse circuit according to this embodiment may have a similar configuration to the synapse circuit described in FIG. 1. In the embodiment of FIG. 19, the 'voltage source' connected to the first electrode E1 of the capacitor CP and the 'second power source' connected to the second source S2 of the depression transistor T_{D} may be integrated or may be identical to each other. In other words, the first electrode E1 of the capacitor CP and the second source S2 of the depression transistor T_{D} may be connected (coupled) to each other, and the same voltage (i.e., V_{BE}) may be applied to the first electrode E1 and the second source S2. Except for this, the remaining circuit configuration may be the same or similar to that described in FIG. 1. In the case of the embodiment of FIG. 19, the voltage source connected to the first electrode E1 and the second source S2 may not be a constant voltage source.

In the embodiment of FIG. 19, a programming selection operation may be performed easily by using the voltage (i.e., V_{BE}) applied to the first electrode E1 of the capacitor CP and the second source S2 of the depression transistor T_{D}.

When programming is not desired, it is possible to maintain the voltage applied to the first electrode E1 of the capacitor CP and the second source S2 of the depression transistor T_{D} to a sufficiently high voltage (for example, V_{DD} or a positive voltage level similar to V_{DD}).

In the case of the potentiation transistor T_{P}, since the corresponding voltages may be defined in the order of V_{DD}, V_{N1,ON}, V_{CAP} + V_{BE} according to the order of the first drain D1, first gate G1, and first source S1 nodes, even if a high signal is input to the first gate G1, a sufficiently strong off voltage may be applied to the first source S1 or the first drain D1. Here, V_{N1,ON} represents the turn-on voltage applied to the first gate G1, and V_{CAP} represents the voltage caused by the charges charged in the capacitor CP. For example, if the condition V_{GS1} = max(V_{N1,ON} - V_{DD}, V_{N1,ON} - V_{CAP} - V_{BE}) < Vₜₕ₁ is satisfied, even if a high signal is applied to the first gate G1, the potentiation transistor T_{P} may not turned on. V_{GS1} represents the voltage between the gate and source of the potentiation transistor T_{P}, and Vₜₕ₁ represents the threshold voltage of the potentiation transistor T_{P}. If the higher value (i.e., max) of V_{N1,ON} - V_{DD} and V_{N1,ON} - V_{CAP} - V_{BE} is less than Vₜₕ₁, the potentiation transistor T_{P} may not be turned on. Furthermore, if both of V_{N1,ON} - V_{DD} and V_{N1,ON} - V_{CAP} - V_{BE} are smaller than Vₜₕ₁, the potentiation transistor T_{P} may not be turned on.

In the case of the depression transistor T_{D}, the corresponding voltages may be defined in the order of V_{CAP} + V_{BE}, V_{N2,ON}, V_{BE} according to the order of the second drain D2, second gate G2, and second source S2 nodes. Here, V_{N2,ON} represents the turn-on voltage applied to the second gate G2. For example, if the condition V_{GS2} = max(V_{N2,ON} - V_{BE}, V_{N2,ON} - V_{CAP} - V_{BE}) < Vₜₕ₂ is satisfied, even if a high signal is applied to the second gate G2, the depression transistor T_{D} may not be turned on. V_{GS2} represents the voltage between the gate and source of the depression transistor T_{D}, and Vₜₕ₂ represents the threshold voltage of the depression transistor T_{D}. If the high value (i.e., max) of V_{N2,ON} - V_{BE} and V_{N2,ON} - V_{CAP} - V_{BE} is less than Vₜₕ₂, the depression transistor T_{2D} may not be turned on. Furthermore, if both of V_{N2,ON} - V_{BE} and V_{N2,ON} - V_{CAP} - V_{BE} are both smaller than Vₜₕ₂, the depression transistor T_{D} may not be turned on.

When programming is desired, by reducing the voltage applied to the first electrode E1 of the capacitor CP and the second source S2 of the depression transistor T_{D} (to GND voltage or a voltage similar to the GND voltage, as a non-limiting example), it is possible to allow current to flow through the potentiation transistor T_{P} and depression transistor T_{D}. When two conditions, that is, first, a high signal enters the first gate G1 or the second gate G2, and second, a low voltage (lower than the voltage to prevent programming) is applied to the first electrode E1 of the capacitor CP and the second source S2 of the depression transistor T_{D}, are satisfied simultaneously, the programming may occur. Here, the low voltage applied to the first electrode E1 of the capacitor CP and the second source S2 of the depression transistor T_{D} may be a GND voltage, a positive (+) voltage, or a negative (-) voltage.

When using the synapse circuit according to the embodiment shown in FIG. 19, it is possible to implement an array structure and driving method which may perform a selection operation at the synapse without using a dual gate, double gate, or AND gate.

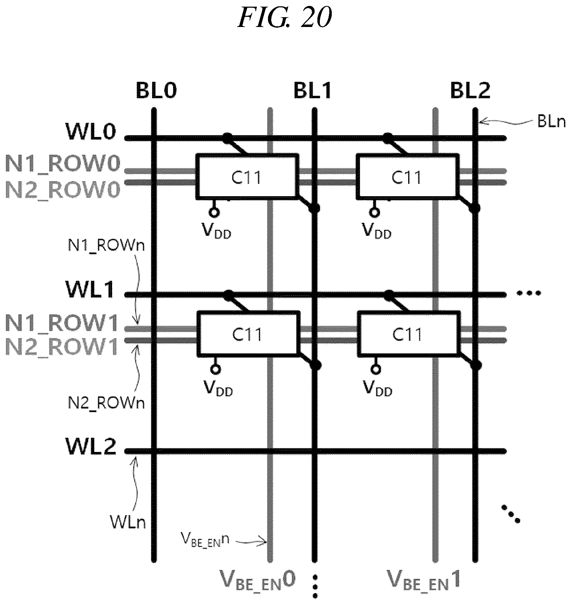

FIG. 20 is a circuit diagram illustrating a synapse circuit according to another embodiment of the present invention.

Referring to FIG. 20, the synapse circuit according to the present embodiment may include a plurality of word lines WLn, a plurality of bit lines BLn crossing the plurality of word lines WLn, and a plurality of unit cells C11 disposed at the intersection of the plurality of word lines WLn and the plurality of bit lines BLn. Each of the plurality of unit cells C11 may include the unit circuit configuration (3T1C unit circuit configuration) described with reference to FIG. 19.

The synapse circuit may include a plurality of N1 signal lines (N1_ROWn) and a plurality of N2 signal lines (N2_ROWn). The N1 signal line (N1_ROWn) may be connected to the first gate (G1 in FIG. 19) of the unit cell C11, and the N2 signal line (N2_ROWn) may be connected to the second gate (G2 in FIG. 19) of the unit cell C11. The N1 signal line (N1_ROWn) may be referred to as a first signal line, and the N2 signal line (N2_ROWn) may be referred to as a second signal line. Furthermore, the synapse circuit may further include a V_{BE} signal line (V_{BE_EN}n) perpendicular to the N1 signal line (N1_ROWn) and the N2 signal line (N2_ROWn). A plurality of V_{BE} signal line (V_{BE_EN}n) may be provided. The V_{BE} signal line (V_{BE_EN}n) may be connected to the first electrode E1 of the capacitor CP and the second source S2 of the depression transistor T_{D} described in FIG. 19. That is, the V_{BE} signal line (V_{BE_EN}n) may be connected to the voltage source described in FIG. 19. The V_{BE} signal line (V_{BE_EN}n) may be referred to as a third signal line. The N1 signal line (N1_ROWn) and the N2 signal line (N2_ROWn) may be row signal lines, and the V_{BE} signal line (V_{BE_EN}n) may be a column signal line. However, in another embodiment, the N1 signal line (N1_ROWn) and the N2 signal line (N2_ROWn) may be a column signal line, and V_{BE} signal line (V_{BE_EN}n) may be a row signal line.

One N1 signal line (N1_ROWn), one N2 signal line (N2_ROWn), and one V_{BE} signal line (V_{BE_EN}n) may be connected to each unit cell C11. In addition, a first power source for applying V_{DD} may be connected to the unit cell C11. The first power source may be commonly connected to a plurality of unit cells C11. The synapse circuit in FIG. 20 may be said to have an array structure (crossbar array structure).

According to the embodiment shown in FIG. 20, an array structure and driving method capable of performing a selection operation at a synapse may be implemented without using a dual gate, double gate, or AND gate. In addition, the voltage (i.e., V_{BE}) applied to the first electrode E1 of the capacitor CP and the second source S2 of the depression transistor T_{D} is not provided globally throughout the circuit, and may be provided through a V_{BE} signal line (V_{BE_EN}n) extending in a direction perpendicular to N1 signal line (N1_ROWn) and N2 signal line (N2_ROWn). In this case, as compared to the embodiment of FIG. 14, an effect that one signal line (line wiring) is reduced may be obtained.

According to an embodiment of the present invention, a neuromorphic device to which the synapse circuit according to the above-described embodiment is applied, and a system thereof may be constructed. The configuration of neuromorphic devices and systems including synapse circuits is well known, and detailed description thereof will be omitted.

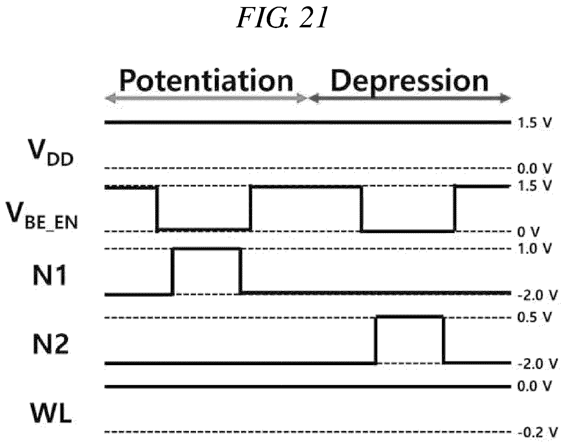

FIG. 21 is a signal waveform diagram for explaining an operation method of a synapse circuit according to another embodiment of the present invention. FIG. 21 may relate to the synapse circuit described with reference to FIGS. 19 and 20.

Referring to FIG. 21, the operation method of the synapse circuit according to the present embodiment may include a step for applying a high voltage corresponding to a positive (+) voltage to the first electrode E1 of the capacitor CP and the depression transistor T_{D} through the voltage source; and a step for applying a low voltage lower than the high voltage to the first electrode E1 of the capacitor CP and the depression transistor T_{D} through the voltage source. The voltage applied to the first electrode E1 of the capacitor CP and the second source S2 of the depression transistor T_{D} through the voltage source may be V_{BE} described in FIG. 19, and is indicated as V_{BE_EN} in FIG. 21.

The potentiation transistor T_{P} and the depression transistor T_{D} are not turned on by applying a high voltage corresponding to a positive (+) voltage to the first electrode E1 of the capacitor CP and the depression transistor T_{D}, so that programming of these may be prevented. Meanwhile, the potentiation transistor T_{P} and the depression transistor T_{D} may be turned on by applying a low voltage lower than the high voltage to the first electrode E1 of the capacitor CP and the depression transistor T_{P}, and as a result of it, programming for one of them may be performed.

In the step for applying the low voltage to the first electrode E1 and the depression transistor T_{D} of the capacitor CP through the voltage source, a potentiation operation for the capacitor CP may be performed by using the potentiation transistor T_{P} or a depression operation for the capacitor CP may be performed by using the depression transistor T_{D}. In other words, while applying the low voltage to the first electrode E1 of the capacitor CP and the depression transistor T_{D} through the voltage source, a potentiation operation for the capacitor CP may be performed by using the potentiation transistor T_{P}, or a depression operation may be performed for the capacitor CP by using the depression transistor T_{D}. During a potentiation operation, a high voltage may be applied to the first gate G1 of the potentiation transistor T_{P} (refer to N1 voltage). During a depression operation, a high voltage may be applied to the second gate G2 of the depression transistor T_{D} (refer to N2 voltage). The voltage levels (values) shown in FIG. 21 are merely an example and may be changed.

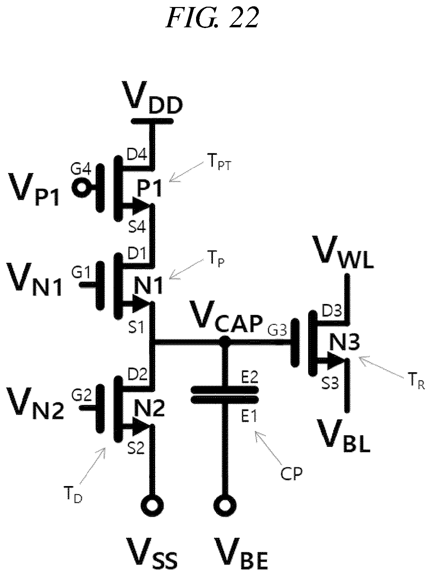

FIG. 22 is a circuit diagram illustrating a synapse circuit according to another embodiment of the present invention.

Referring to FIG. 22, the synapse circuit according to this embodiment may have a similar configuration to the synapse circuit described in FIG. 1. In the embodiment of FIG. 22, a p-type transistor T_{PT} connected between the potentiation transistor T_{P} and the first power source (i.e., V_{DD} power source) may be further provided. The p-type transistor T_{PT} may include a fourth source S4 connected to the first drain D1, a fourth drain D4 connected to the first power source, and a fourth gate G4 for applying a third control signal. The remaining circuit configuration, except for further including a p-type transistor T_{PT}, may be the same or similar to that described in FIG. 1.

According to one embodiment, the channel resistance of the p-type transistor T_{PT} may be higher (larger) than the channel resistance of the potentiation transistor T_{P}. In other words, the resistance of the p-type transistor T_{PT} may be higher (larger) than the resistance of the potentiation transistor T_{P}. The channel resistance may be the channel resistance in the off state of the corresponding transistor. The p-type transistor T_{PT} may be a transistor based on a non-oxide semiconductor such as Si, Ge, SiGe, etc., or a transistor based on an oxide semiconductor. As a non-limiting example, the p-type transistor T_{PT} may be a p-channel metal-oxide-semiconductor (PMOS) transistor. The p-type transistor T_{PT} may include any channel material which may be applied to a typical p-type transistor.

According to the embodiment of FIG. 22, linear weight potentiation may be achieved by connecting the p-type transistor T_{PT} in series to the potentiation transistor T_{P}. It may be configured such that the resistance of the p-type transistor T_{PT} is made higher than that of the potentiation transistor T_{P}, the potentiation transistor T_{P} functions only as a switch, and the current which actually flows is determined by the p-type transistor T_{PT}. The methods for making the channel resistance of the p-type transistor T_{PT} higher than that of the potentiation transistor T_{P} may include channel doping, adjusting the transistor size, and changing the channel deposition conditions of the potentiation transistor T_{P}.

For excellent data retention characteristics, it is not possible to use only a single p-type transistor T_{PT} with a relatively high leakage current, and it may be necessary to connect the potentiation transistor T_{P} to which an oxide semiconductor which may block current well is applied to the p-type transistor T_{PT} in series. As V_{DD}, V_{BE}, Vss and the like, an arbitrary voltage may be applied, and one of the methods proposed in the previously described embodiments may be applied as an element selection method. For example, for device selection, AND gate, dual gate or double gate configurations may be applied.

During the potentiation operation in the synapse circuit operation method according to the embodiment of FIG. 22, a linear potentiation operation may be performed by application of the p-type transistor T_{PT} without application of a V_{BE} voltage corresponding to a positive (+) voltage. Meanwhile, during a depression operation, a V_{BE} voltage corresponding to a positive (+) voltage may be applied, and as a result, a linear depression operation may be possible. In the step for performing a depression operation for the capacitor CP by using the depression transistor T_{D}, the positive (+) voltage may be applied to the first electrode E1 of the capacitor CP by using the voltage source. In the case of the embodiment of FIG. 22, a linear weight potentiation process may be possible even without applying a predetermined positive (+) voltage to the first electrode E1 of the capacitor CP. In addition, since the potentiation transistor T_{P} to which an oxide semiconductor is applied is connected in series to the p-type transistor T_{PT}, sufficient data retention ability may be secured. It may be considered that the potentiation transistor T_{P} and the p-type transistor T_{PT} constitute one 'potentiation circuit'.

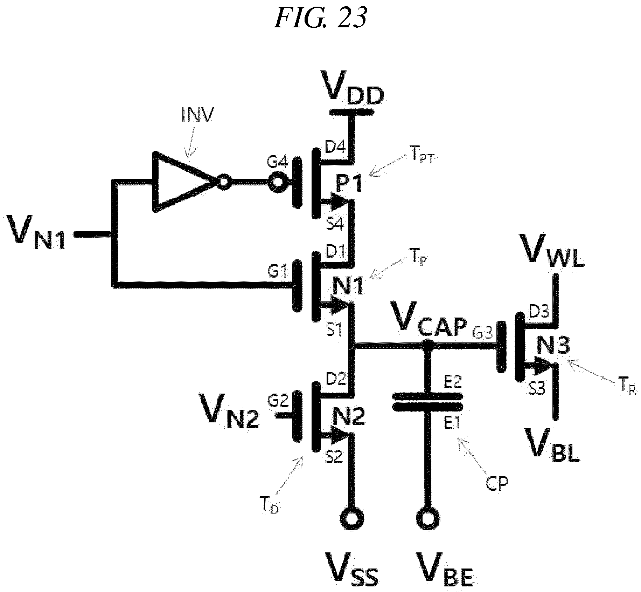

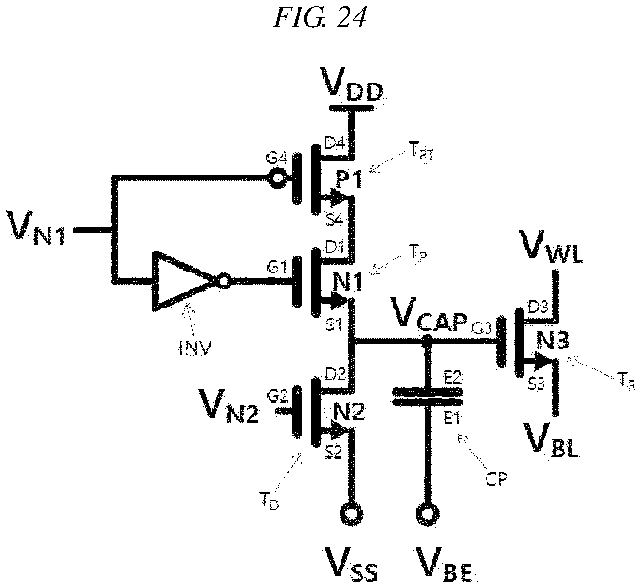

According to another embodiment of the present invention, since the p-type transistor T_{PT} and the potentiation transistor T_{P} may always be turned on at the same time (or substantially simultaneously), it is possible to configure a circuit wherein a weight update operation may be performed with one input signal by using an inverter. The examples are shown in FIG. 23 and FIG. 24.

FIG. 23 and FIG. 24 are circuit diagrams illustrating a synapse circuit according to another embodiment of the present invention. FIG. 23 and FIG. 24 show a circuit structure modified from FIG. 22.

Referring to FIG. 23 and FIG. 24, the fourth gate G4 of the p-type transistor T_{PT} and the first gate G1 of the potentiation transistor T_{P} may be connected to one signal input unit (an input indicated as V_{N1}), and an inverter INV may be further disposed between the signal input unit and the fourth gate G4 or between the signal input unit and the first gate G1. FIG. 23 shows a case where the inverter INV is placed between the signal input unit and the fourth gate G4, and FIG. 24 shows a case where the inverter INV is placed between the signal input unit and the first gate G1. Since the inverter INV may play the role of converting a high signal into a low signal and a low signal into a high signal, both of the p-type transistor T_{PT} and the potentiation transistor T_{P} can be turned on with one input signal by using the inverter INV. Therefore, a weight update operation can be performed with one input signal by using the inverter INV.

According to the embodiments of the present invention described above, a synapse circuit with low leakage current may be implemented by applying an n-type oxide thin film transistor including an oxide semiconductor channel. In particular, according to embodiments, it is possible to implement a synapse circuit which may have high accuracy during long-term inference and learning processes by allowing learned weights to be stored for a long time by using an n-type oxide thin film transistor. Furthermore, according to embodiments of the present invention, an operation method of a synapse circuit which may improve the linearity and symmetry of weight update in the operation of the synapse circuit described above may be implemented.

In this specification, the preferred embodiments of the present invention have been disclosed, and although specific terms have been used, they are only used in a general sense to easily explain the technological content of the present invention and to help understanding the present invention, and they are not used to limit the scope of the present invention. It is obvious to those having ordinary skill in the related art to which the present invention belong that other modifications based on the technological idea of the present invention may be implemented in addition to the embodiments disclosed herein. It will be understood to those having ordinary skill in the related art that in connection with a synapse circuit and operation method thereof according to the embodiments described with reference to FIGS. 1 to 24, and a neuromorphic device including the synapse circuit, various substitutions, changes, and modifications may be made without departing from the technological spirit of the present invention. Therefore, the scope of the invention should not be determined by the described embodiments, but should be determined by the technological concepts described in the claims. As a specific example, it will be appreciated that at least two configurations among the embodiments described with reference to FIGS. 5 to 13 may be mixed/combined. Therefore, the scope of the invention should not be determined by the described embodiments, but by the technological concepts described in the patent claims.

The embodiments of the present invention may be applied to electronic circuits/devices, operation methods thereof, and apparatuses including the electronic circuits/devices. The embodiments of the present invention may be applied to synapse circuits, operating methods thereof, and neuromorphic devices including a synapse circuit.

## Claims

1. A synapse circuit comprising:
a capacitor including a first electrode and a second electrode and a dielectric layer between them, wherein the first electrode is connected to a voltage source capable of applying a positive (+) voltage;
a potentiation transistor having a first source connected to the second electrode, a first drain connected to a first power source, and a first gate for applying a first control signal;
a depression transistor having a second drain connected to the second electrode, a second source connected to a second power source, and a second gate for applying a second control signal; and
a read transistor having a third gate connected to the second electrode, a third source connected to a word line, and a third drain connected to a bit line,
wherein the potentiation transistor, the depression transistor, and the read transistor are n-type oxide thin film transistors including an oxide semiconductor channel, and
wherein the synapse circuit has a 3T1C (3-transistor 1-capacitor) unit circuit configuration composed of the potentiation transistor, the depression transistor, the read transistor, and the capacitor.

2. The synapse circuit of claim 1, wherein the oxide semiconductor channel includes at least one of amorphous InGaZnO, InGaO, InSnO, and InSnZnO.

3. The synapse circuit of claim 1, wherein the synapse circuit is configured so that a first gate voltage is applied to the first gate as the first control signal, and a second gate voltage which is lower than the first gate voltage is applied to the second gate as the second control signal.

4. The synapse circuit of claim 1, wherein the synapse circuit is configured so that in a potentiation operation for the capacitor using the potentiation transistor and a depression operation for the capacitor using the depression transistor, the positive (+) voltage is applied to the first electrode of the capacitor by using the voltage source.

5. The synapse circuit of claim 1, wherein the synapse circuit comprises a unit cell, and the unit cell includes the 3T1C unit circuit configuration and a selection device for a selection operation on the 3T1C unit circuit configuration.

6. The synapse circuit of claim 5, wherein the selection device includes a first AND gate circuit connected to the first gate and a second AND gate circuit connected to the second gate.

7. The synapse circuit of claim 5, wherein the selection device includes a first selection transistor connected to the first gate and a second selection transistor connected to the second gate, and
each of the first selection transistor and the second selection transistor has a dual gate structure or a double gate structure.

8. The synapse circuit of claim 5, wherein the selection device includes a 1-1 selection transistor and a 1-2 selection transistor connected in series to the first gate, and a 2-1 selection transistor and a 2-2 selection transistor connected in series to the second gate.

9. The synapse circuit of claim 1, wherein each of the potentiation transistor and the depression transistor has a dual gate structure or a double gate structure for a selection operation.

10. The synapse circuit of claim 1, wherein two potentiation transistors are connected in series and arranged between the second electrode and the first power source,
two depression transistors are connected in series and arranged between the second electrode and the second power source, and
the synapse circuit is configured to perform a selection operation by using the two potentiation transistors and the two depression transistors.

11. The synapse circuit of claim 1, comprising:
a plurality of the word lines;
a plurality of bit lines crossing the plurality of word lines; and
a plurality of unit cells disposed at intersections of the plurality of word lines and the plurality of bit lines, and each of which includes the 3T1C unit circuit configuration.

12. The synapse circuit of claim 1, wherein the voltage source and the second power source are integrated or identical to each other.

13. The synapse circuit of claim 12, comprising:
a first signal line connected to the first gate;
a second signal line connected to the second gate; and
a third signal line perpendicular to the first and second signal lines and connected to the voltage source.

14. The synapse circuit of claim 1, further comprising a p-type transistor connected between the potentiation transistor and the first power source, and
wherein the p-type transistor includes a fourth source connected to the first drain, a fourth drain connected to the first power source, and a fourth gate for applying a third control signal.

15. The synapse circuit of claim 14, wherein a channel resistance of the p-type transistor is higher than a channel resistance of the potentiation transistor.

16. The synapse circuit of claim 14, wherein the fourth gate of the p-type transistor and the first gate of the potentiation transistor are connected to one signal input unit, and
the synapse circuit further includes an inverter disposed between the signal input unit and the fourth gate or between the signal input unit and the first gate.

17. A neuromorphic device comprising the synapse circuit according to any one of claims 1 to 16.

18. An operation method of a synapse circuit according to claim 1, comprising:
performing a depression operation on the capacitor by using the depression transistor, and
wherein the positive (+) voltage is applied to the first electrode of the capacitor by using the voltage source in the performing a depression operation on the capacitor.

19. The operation method of a synapse circuit of claim 18, comprising performing a potentiation operation on the capacitor by using the potentiation transistor, and
wherein the positive (+) voltage is be applied to the first electrode of the capacitor by using the voltage source in the performing a potentiation operation on the capacitor.

20. The operation method of a synapse circuit of claim 18, wherein a first gate voltage applied to the first gate as the first control signal is higher than a second gate voltage applied to the second gate as the second control signal.

21. An operation method of a synapse circuit according to claim 12, comprising:
applying a high voltage corresponding to a positive (+) voltage to the first electrode of the capacitor and the second source of the depression transistor; and
applying a low voltage lower than the high voltage to the first electrode of the capacitor and the second source of the depression transistor, and
wherein, in the applying a low voltage to the first electrode of the capacitor and the second source of the depression transistor, a potentiation operation is performed on the capacitor by using the potentiation transistor, or a depression operation is performed on the capacitor by using the depression transistor.
